# EUROPEAN PATENT APPLICATION

(11) **EP 3 154 016 A1**
(43) Date of publication of application: **12.04.2017**
(21) Application number: 15188741.1
(22) Date of filing: 07.10.2015
(51) Int. Cl.: G06Q 50/08, G06Q 10/06, G06F 17/50, G06Q 10/10

(54) **METHOD FOR AUTOMATIC VALIDATION OF ARCHITECTURAL BUILDING PLANS**

(71) Applicant: Luxembourg Institute of Science and Technology (LIST), 4362 Esch-sur-Alzette (LU)
(72) Inventor: MAUGER, Cyril, 2430 Luxembourg (LU)
(74) Representative: Lecomte & Partners

(57) **Abstract**

The invention proposes a method for automatically validating at least one architectural building plan against a set of building requirements. From heterogeneously formatted inputs describing the building plan as well as the building requirements, the method generates a machine readable unifying data model, which is then automatically analyzed.

## Description

### Technical field

The present invention relates to the field of building, and in particular to allocating building resources efficiently early on in a building process, with respect to functional constraints of a building or with respect to the environmental impact of a building.

### Background of the invention

A construction project life-cycle is composed of complex activities, from inception to demolition, involving numerous and heterogeneous actors during relatively short periods. The organization of these activities can be multiple depending on several criteria (e.g. the building type, the contractual framework, the public or private stakeholders, the budget and time allocated, etc.). A building may be seen as a complex system. Different actors involved during the construction and usage of the building have different views of the same components of such a complex system.

A client may for example define a building in terms of functional requirements or constraints that need to be fulfilled. At the design stage, an architect or a team of consultants represents a building using graphical representations. Building contractors involving multiple heterogeneous actors intervene during a prolonged time period in temporally limited construction phases of the building. Each of these actors has their own view of the building. Finally, a user of the building, who dwells or works therein, often has a purely functional view of the resulting building. According to the work practices of each actor involved in such a building construction process, each actor uses their own format or descriptive language for formalizing those aspects of the building, which are most important to the actions he is to perform during the construction process. As these heterogeneous viewpoints are generally only available in very heterogeneous formats, it is inherently difficult to reconcile these viewpoints, for example for the purpose of verifying consistency between them.

In practice, the experience and skill of a particular actor have a strong impact on the overall outcome in terms of convergence of these viewpoints. However, the convergence of these viewpoints is a key factor for enabling an efficient building construction process: client requirements must be met by a design suggested by an architect, while enabling a user of the building to efficiently perform a set of activities in the spaces or rooms of the building. Nowadays one has to rely on the skills, expertise, and acquired know-how of single persons or teams for comparing these viewpoints. This results in a highly subjective and untraceable process, leading for example to sub-optimal allocations of building materials or sub-optimal allocations of room spaces and layouts in a building aimed at achieving a set predetermined activities that a client or user intends to perform therein.

### Technical problem to be solved

It is therefore an objective of the present invention to provide a method and device, which at least alleviate some of the aforementioned problems of the state of the art. In particular, it is an objective of the invention to provide a method for automatically validating an architectural building plan against heterogeneous target criteria, including but not limited to building resources required for constructing the building, properties or attributes provided by the constructed building, and activities that are to be fulfilled in the constructed building.

### Summary of the invention

According to a first aspect of the present invention, there is provided a method for automatic validation of an architectural building plan. The method comprises the following steps:
a) providing a representation of building requirements in a first memory element, comprising:
   - a list describing a first set of rooms required by a building;
   - a description of a set of activities, wherein each activity is associated with an ordered sequence of rooms indicating transitions between rooms that are required for said activity, and
   - a first set of constraints on building resources, which are required for the construction of the building, wherein each constraint is associated with at least one room of the first set of rooms and/or at least one activity;
b) providing a representation of an architectural building plan in a second memory element, comprising:
   - a graphical representation of said plan, including a second set of rooms, and
   - a description of a set of building resources, wherein each resource is associated with at least one room of the second set of rooms;
c) validating the compliance of said architectural building plan against said building requirements.
The step of validating comprises:
d) generating, using computing means having access to said first memory element, a first dataset comprising:
   - a vertex for each room of the first set of rooms;
   - a plurality of sets of edges, each set of edges representing one activity of the activities, wherein two vertices are linked by an edge if the corresponding activity is associated with, and requires a transition between the corresponding rooms;
e) generating, using computing means having access to said second memory element, a second dataset comprising:
   - a vertex for each room of the second set of rooms;
   - a set of edges, wherein two vertices are linked by an edge if the corresponding rooms communicate;
f) comparing, using computing means, the first and second datasets and validating said architectural building plan, if:
   - there exists a mapping that maps the set of vertices and edges of said second dataset onto the set of vertices and edges of said first dataset, and
   - if the building resources satisfy the constraints.

An activity may preferably be an activity that is performed by a user of the constructed building. Alternatively, an activity may be related to a facility or service that may be realized using the building resources. Such an activity may comprise the provision of water in a room, the provision of electricity, or the provision of access to a data communication network. The transitions required by an activity may therefore be transitions of a user or of a facility, or piece of furniture.

Two rooms of a building communicate if there is pathway connecting the two rooms. The pathway may be a door suitable for the transition of a user of the building, or a pathway suitable for passing a conduit or cable there through.

The building requirements may further comprise a second set of constraints on properties of the building. Each constraint of set second set may preferably be associated with at least one room of the first set of rooms and/or at least one activity. The architectural building plan may further comprise a description of a set of properties provided according to the plan, wherein each property is associated with at least one room of the second set of rooms. Advantageously, the architectural building plan may be validated if, additionally, the provided properties satisfy the corresponding constraints.

Preferably, the set of properties may comprise any of a space in m², a volume in m³, heat consumption in kWh or a floor loading in kg/m².

The set of building resources may preferably comprise any of a number of bricks, doors, windows, furniture or a computer network equipment.

The step of providing a representation of building requirement may preferably further comprise the following steps:
- identifying, for each activity of said description of a set of activities, using computing means, an ordered sequence of rooms indicating transitions between rooms that are required for said activity;
- generating, using computing means, the list of rooms based on the rooms identified in the previous step.

Preferably, the step of generating said second dataset from said representation of an architectural building plan may further comprise:
- detecting, using computing means, lines drawn on said building plan;
- identifying at least one room on said building plan based on said detected lines;
- adding a vertex to said second dataset for each identified wall room;
- connecting two vertexes of said second dataset by an edge if the corresponding rooms on said building plan communicate.

Preferably, the identification of a room depends on the position and type of detected lines.

Preferably, a plurality of different architectural building plans may be validated against said building requirements.

The method may further preferably comprise a subsequent step of selecting for physical realization or construction, among the validated architectural plans, the architectural plan which uses the least building resources.

Preferably, the method may comprise a further subsequent step of selecting for realization or construction, among the validated architectural plans, the architectural plan, the building resources and/or properties of which generate the least environmental impact according to a predetermined metric.

The representation of building requirements may preferably be provided in textual and/or in graphical form.

Preferably, the method may further comprise a subsequent step of displaying, using display means, said validated or selected architectural building plan, together with the corresponding building resources allocated for the realization or construction of the building.

For each validated and/or non-validated architectural building plan, each building resource and/or building property may be displayed on said display means, together with the corresponding building resource constraint and/or property constraint. This enables a user of the computing means to identify, for example, the cause of non-validation of a particular architectural building plan.

According to a further aspect of the invention, there is provided a device comprising at least one memory element and computing means configured to perform the method steps according to the invention.

The device may further comprise image acquisition means and/or display means, operatively connected to said computing means.

According to another aspect of the invention, a computer capable of carrying out the method according to the invention is provided.

According to yet another aspect of the invention, a computer program comprising computer readable code means is provided, which when they are run on a computer, causes the computer to carry out the method according to the invention.

According to still another aspect of the invention, there is provided a computer program product comprising a computer-readable medium on which the computer program according to the present invention is stored.

By using the method according to the present invention, objective and automatic comparison of different viewpoints of a building, as they are used at different stages of a construction process, is enabled. The different viewpoints define a building in terms of activities to be performed in the rooms of a building, and for example in terms of an architectural design plan of the building. The invention suggests using a machine-readable universal representation, or dataset, in the form of a graph having vertices and edges, for uniformly representing the multiple viewpoints that are traditionally only available in heterogeneous human-readable modalities. The corresponding datasets are automatically generated and may be objectively compared to one another. This enables for example the selection of a building plan among a plurality of proposed building plans, which results in an optimal building resource allocation (bricks, mortar, ...) for the construction of the building, while allowing end-users of the building to fulfill their building-based activities efficiently. Alternatively, depending on the evaluation metric chosen, a building plan that results in a constructed building having a minimal environmental impact (lowest power consumption per m²) may be automatically identified among a plurality of architectural suggestions. The resulting validated plan is one which allocates the corresponding building resources so as to fulfill a range of technical target criteria.

### Brief description of the drawings

Several embodiments of the present invention are illustrated by way of figures, which do not limit the scope of the invention, wherein:
- figure 1 is a flow chart illustrating the main method steps according to a preferred embodiment of the invention;
- figure 2 is a schematic illustration showing the interactions as required by the method steps according to a preferred embodiment of the invention;
- figure 3 is a flow chart illustrating method steps according to a preferred embodiment of the invention.

### Detailed description of the invention

This section describes the invention in further detail based on preferred embodiments and on the figures. Unless specifically indicated otherwise, specific features, which are described in the context of a particular embodiment of the invention, may be readily combined with features described in the context of other embodiments of the invention.

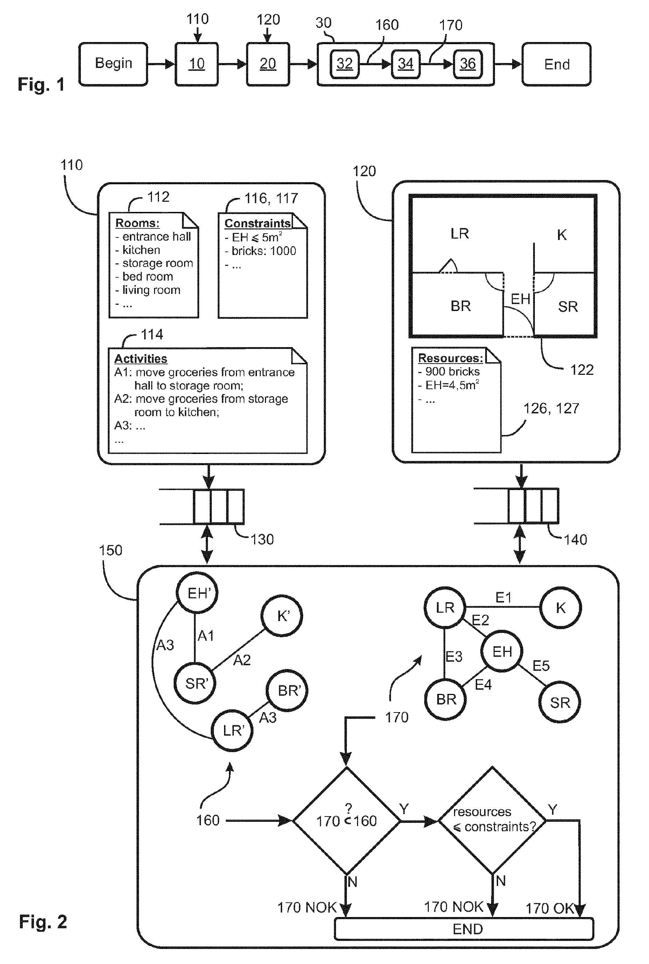

Figure 1 shows the main method steps according to a preferred embodiment of the invention. In a first step 10, a representation of building requirements 110 is provided in a memory element of a computing device.

The representation of building requirements 110 is further outlined in Figure 2. Figure 2 illustrates the concepts of which the invention makes use in an exemplary and non-limiting setting. The building requirements 110 may be considered as a wish list that is drawn up by a client who intends to commission the construction of a building. The requirements 110 are provided in said memory element 130 and comprise a list or description of a first set of rooms 112 that are required by the building, a set of activities or functions 114, which should be enabled by the building, and a set of building resource constraints 116, which should be respected during the construction of the building. In the example of Figure 2, the first set of rooms 112 comprises an entrance hall, EH', a kitchen, K', a storage room, SR', a bed room, BR' and a living room, LR'. It will be appreciated that this is a simple example aimed at the explanation of the invention only.

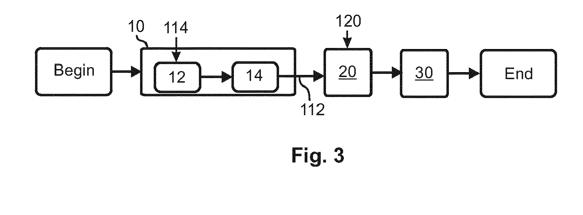

The exemplary set of required activities 114 comprises activity A1, "move groceries from entrance hall to storage room", and implies a required transition between rooms EH' and SR'. The ordered sequence (EH', SR') is therefore associated with activity A1. Activity A2 requires to "move groceries from storage room to kitchen" and is therefore associated with the ordered room sequence (SR', K). A3 is a further exemplary activity. While the activities are given in textual form in this example, they may be provided in heterogeneous input formats which are best suited for their representation, including for example Unified Modeling Language, UML, diagrams or similar representations as such known in the art. According to a preferred embodiment, the list of rooms 112 is first extracted from a description of required activities 114, as illustrated by step 12 on Figure 3. The description of activities is analyzed and parsed. Terms identifying rooms, as well as transitions between rooms, are extracted. This allows for generating, for each activity, an ordered sequence of rooms required for performing the activity. Among all activities, the overall resulting list of rooms may further be shortened by identifying duplicates on the list, i.e., by identifying rooms which are required for a plurality of activities. This is illustrated by step 14 on Figure 3.

The representation of building requirements 110 further comprises a first set of constraints 116 on building resources, which are required for the construction of the building. Each constraint is associated with at least one room of the first set of rooms 112 and/or at least one activity, A1, A2, A3. The set of constraints 116 includes for example constraints on the building materials that are to be used, or that are available for realizing or constructing a room, a set of rooms, or the entire building. These building materials may for example include bricks, mortar, windows, doors, insulation material, lengths of pipes and conduits and the like. A resource constraint linked to an activity may for example constrain the distance that a user has to walk in the building to perform A1 to be shorter than a predefined upper limit. In the dummy example of Figure 2, a building resource constraint is illustrated on the total number of bricks, which should be less than 1000. According to a preferred embodiment of the invention, a second set of constraints 117 may impose limits on properties of the building, wherein each constraint is associated with at least one room of the first set of rooms. A property of a room or building may for example be the space or volume provided by the room once it has been constructed, or its energy consumption. The constraints in sets 116, 117 may be expressed in any suitable form. In particular, they might be strict constraints, inequalities or constraints permitting tolerable deviations therefrom within a predetermined tolerance range. For example, a constraint on a resource X may be defined in terms of X being equal to Y +/- 10%. The resource constraints may also be indirectly expressed by way of constraints on the corresponding costs.

In a second step 20 as show in Figure 1, a representation of an architectural building plan 120 is provided in a memory element of a computing device. Steps 10 and 20 may either be performed subsequently or contemporaneously.

The representation of an architectural building plan 120 is further outlined in Figure 2. The building plan 120 may be considered as a proposition or suggestion drawn up by an architect in order to accommodate a client's needs. The representation of an architectural building plan 120 comprises a graphical representation of the plan, showing a second set of rooms 122, typically in a two-dimensional planar view or in a three-dimensional view. In the example of Figure 2, the second set of rooms 122 comprises an entrance hall, EH, a kitchen, K, a storage room, SR, a bed room, BR and a living room, LR. The representation 120 also comprises a set of building resources 126, which are needed to construct the building. Each resource may be a building material that is associated with at least one room, a set of rooms, or with the entire building. These building materials may for example include bricks, mortar, windows, doors, insulation material, lengths of pipes and conduits and the like. In the example of Figure 2, 900 bricks are needed to construct the building shown on the graphical representation 122. The set of building resources 126 may be provided by a list or by any suitable representation. In particular, it should be noted that the representation format in which the set of building resources 126 is provided may be entirely different form the representation format according to which the set of building resource constraints 116 are provided.

In a further step 30 as show in in Figure 1, the architectural building plan 120 is validated against the building requirements 110. Step 30 implies the step 32 of generating a first dataset 160, the step 34 of generating a second dataset 170 and the comparison 36 of said datasets. These steps will be further explained using the example of Figure 2.

The method relies on computing means 150, such as a programmable central processing unit, CPU, of a computing device, which has at least read access rights to the memory elements 130, 140. The memory elements may be physically unitary or disjoint. The memory elements may be physically collocated in a same computing device together with the computing means. Alternatively, the computing means 150 may have remote access to the memory elements 130, 140 through a communication network and appropriate data transmission and data reception means. Such computing architectures are as such known in the art and will not be described in further details in the context of the present invention. In particular, the memory elements 130, 140 may be structured memory elements such as databases that are part of an information system.

The inputs 110, 120 represent building requirements and an architectural building plan in heterogeneous formats that may not be objectively compared to one another in a traceable manner. The computing means 150 are configured to generate, from these inputs, a first and a second dataset representing the input information. The generated datasets provide the advantage that they may be compared to one another using the computing means 150.

The first dataset 160 is generated using the information stored in memory element 130 and relating to the building requirements 110. If the corresponding information is available in textual form, it is parsed using known processes in order to extract the information describing rooms and/or activities therefrom. Such a parsing process may be assisted by prior semantic knowledge from the field of architecture or construction, which is stored in a database that is advantageously accessible by the computing means 150. Information described in UML diagrams may also be extracted using known methods. A vertex of a graph is generated for each room of the first set of rooms 112. In the example of Figure 2, vertices with labels EH', SR', K', BR', LR' are generated. Further, a plurality of sets of edges is generated, wherein each set of edges corresponds to one activity of the set of activities 116. The set of edges A1 comprises one edge, linking vertex EH' to SR', as the activity A1 requires a transition between the entrance hall and the storage room. The set of edges A2 comprises one edge, linking vertex SR' to K', as the activity A2 requires a transition between the storage room and the kitchen. The exemplary activity A3 requires a transition from the entrance hall to the living room and a further transition from the living room to the bed room, so that the corresponding set of edges A3 comprises two edges, of which one edge connects vertex EH' to vertex LR', and one edge connects vertex LR' to vertex BR'.

The second dataset 170 is generated using the information stored in memory element 140 and in particular using the graphical representation of the architectural building plan. The second set of rooms described in this graphical representation and their physical interconnections are extracted. These interconnections may comprise doorways, windows or spaces foreseen for the passage of conduits or wires. A vertex of a graph is generated for each room of the second set of rooms 112. In the example of Figure 2, vertices with labels EH, SR, K, BR, LR are generated. Further, a set of edges is generated. The edges correspond to the physical interconnections between the rooms of the second set of rooms. Optionally, multiple sets edges may be generated, wherein each set describes a specific interconnection modality, for example there may be one set of edges representing the doorways, one set of edges representing conduits, etc... Returning to the example of Figure 2, and edges E2, E4, E5 link vertex EH to vertices LR, BR and SR, as the living room, bed room and storage room may all be accessed through a door from the entrance hall. Similarly, edge E1 connects vertex LR to vertex K in order to catch the physical connection between the living room and the kitchen. Finally, edge E3 connects vertices LR and BR.

In a particularly preferred embodiment of the invention, the method relies on an image analysis process to automatically generate the required vertices and edges from the graphical representation of the architectural building plan. Lines on the plan typically represent walls or particular openings in walls. The type, width or style of a line defines and dimensions at least partly the depicted item on the plan. Therefore, the corresponding items, such as walls, openings and the like are capable of being identified by computing means configured for identifying line types/styles and their relative positions. In general, the depicted lines define spaces, such as rooms, and their corresponding accesses. Using edge detection techniques as such known in the art, the method may detect a room on a building plan by considering it to be a space enclosed, for example, by at least three walls, possible having door and/or window openings. Curved walls may also enclose rooms. For each detected room, the method generates one vertex of representing the room. If one of the walls comprises a door, an edge will connect the vertex to a further vertex representing the adjacent room. By performing this algorithm iteratively for each detected room, the required graph as described above may be automatically built. Alternatively, a mesh grid may be defined on the architectural building plan, and initially one vertex may be assigned to each square enclosed by grid lines of the mesh. If no wall is detected between adjacent vertices, the two vertices may be merged into one, as they represent the same room. Once all rooms have been detected and represented by a single vertex, their interconnections are added to the model by way of edges connecting the vertices.

The two resulting datasets 160 and 170, which represent graphs, may be stored in a structured database and may be analyzed and/or compared for various purposes using technical means.

The above described generation of datasets 160 and 180 corresponds to steps 32 and 34 respectively, as illustrated in Figure 1. During step 36, the computing means validate the architectural building plan, modeled by the dataset 170 and the set of resources 126 and properties 127, against the building requirements, modeled by the dataset 160 and the sets of constraints 116, 117.

If the graph described by dataset 170 can be mapped onto the graph described by the dataset 160, then all required activities A1, A2, A3 are achievable using the building proposed by the architectural building plan 120. Therefore, the computing means 150 are configured to check if such a mapping may be achieved. In the example of Figure 2, activity A1 is supported by the proposed building plan. Indeed dataset 170 comprises an edge E5 linking vertex EH to vertex SR. This corresponds to the requirement of activity A1, represented by vertex A1 in dataset 160, which links vertices EH' and SR' respectively. Similarly, activity A3 is supported through edges E2 and E3 of dataset 170. However, activity A2 is not supported by the dataset 160. In this example, the architectural building plan is therefore not validated against the requirements 110.

If a plan is validated against the activity requirements, compliance of the resources 126 and/or properties 127 provided according to the building plan is checked against the resource constraints and/or property constraints. This step avoids for example an unnecessary over-dimensioning of a building. If a constraint is not satisfied, a description of the one or more non-validated resources, including a quantifying measure of the resources that resulted in exceeding the constraints, is stored in a memory element for reporting to a user.

If all constraints are satisfied, the building plan is validated. The method according to the invention allows a fully automatic validation of information that is inherently heterogeneous and difficult to understand. This is enabled through an interface provided by the machine-readable datasets 160 and 170 respectively. A building plan, which is validated for construction or physical realization, is therefore certain to result in a building which is capable of accommodating the required activities and to imply an optimal building resource allocation.

According to a further preferred embodiment of the invention, multiple proposed architectural building plans 120 may be validated against the building requirements 110. This does not only allow for an objective comparison between the different proposals, but also allows an automatic selection according to a predetermined metric. For example, among a set of validated building plans, the method may be adapted to identify and select the building plan which minimizes overall energy consumption, which uses the least building resources, or for which the walking distances for performing a particular activity is minimal. Other factors and combinations of such factors are of course possible. The particular metric may be readily adapted by the skilled person depending on the specificities of each particular application in which the described method is put to use, without leaving the scope of the present invention.

Based on the provided examples and the accompanying description thereof, the skilled person will be able to apply the same presented concepts to arbitrarily more complex situations, including multiple rooms, floors or building compounds.

Using the description of the above examples and the accompanying figures, the skilled person is able to implement the method according to the invention in a computer readable form. In particular, the skilled person is able to implement a computer software, which, when run on a computer, executes the method steps as describe here above.

## Claims

1. Method for automatic validation of an architectural building plan (120), comprising the following steps:
a) providing (10) a representation of building requirements (110) in a first memory element (130), comprising:
- a list describing a first set of rooms (112) required by a building;
- a description of a set of activities (114), wherein each activity (A1, A2, A3) is associated with an ordered sequence of rooms indicating transitions between rooms that are required for said activity, and
- a first set of constraints (116) on building resources, which are required for the construction of the building, wherein each constraint is associated with at least one room of the first set of rooms (112) and/or at least one activity (A1, A2, A3);
b) providing (20) a representation of an architectural building plan (120) in a second memory element (140), comprising:
- a graphical representation of said plan, including a second set of rooms (122), and
- a description of a set of building resources (126), wherein each resource is associated with at least one room of the second set of rooms (122);
c) validating (30) the compliance of said architectural building plan (120) against said building requirements (110);
wherein the step of validating comprises:
d) generating (32), using computing means (150) having access to said first memory element (130), a first dataset (160) comprising:
- a vertex (EH', SR', K', BR', LR') for each room of the first set of rooms (112);
- a plurality of sets of edges (A1, A2, A3), each set of edges representing one activity of the activities (116), wherein two vertices are linked by an edge if the corresponding activity is associated with, and requires a transition between the corresponding rooms;
e) generating (34), using computing means (150) having access to said second memory element (140), a second dataset (170) comprising:
- a vertex (EH, SR, K, BR, LR) for each room of the second set of rooms (122);
- a set of edges (E1, E2, E3, E4, E5), wherein two vertices are linked by an edge if the corresponding rooms communicate;
f) comparing (36), using computing means (150), the first and second datasets and validating said architectural building plan (120), if:
- there exists a mapping that maps the set of vertices and edges of said second dataset (170) onto the set of vertices and edges of said first dataset (160), and
- if the building resources (126) satisfy the constraints (116).

2. The method according to claim 1, wherein the building requirements (110) further comprise a second set of constraints (117) on properties of the building, wherein each constraint is associated with at least one room of the first set of rooms (112) and/or at least one activity (A1, A2, A3), and wherein the architectural building plan (120) comprises a description of a set of properties (127) provided according to the plan, wherein each property is associated with at least one room of the second set of rooms (122), and wherein the architectural building plan (120) is validated if, additionally, the provided properties (127) satisfy the constraints (117).

3. The method according to claim 2, wherein the set of properties comprises any of a space in m², a volume in m³, heat consumption in kWh or a floor loading in kg/m²,
and/or wherein the set of building resources comprises any of a number of bricks, doors, windows, furniture or a computer network equipment.

4. The method according to any of claims 1 to 3, wherein the step of providing (10) a representation of building requirement further comprises:
- identifying (12), for each activity (A1, A2, A3) of said description of a set of activities (114), using computing means, an ordered sequence of rooms indicating transitions between rooms that are required for said activity;
- generating (14), using computing means, the list of rooms (112) based on the rooms identified in the previous step.

5. The method according to any of claims 1 to 4, wherein the step of generating said second dataset from said representation of an architectural building plan comprises:
- detecting, using computing means, lines drawn on said building plan;
- identifying at least one room on said building plan based on said detected lines;
- adding a vertex to said second dataset for each identified room;
- connecting two vertexes of said second dataset by an edge if the corresponding rooms on said building plan communicate.

6. The method according to any of claims 1 to 5, wherein a plurality of different architectural building plans are validated against said building requirements.

7. The method according to claim 6, wherein the method comprises a further subsequent step of selecting for construction, among the validated architectural plans, the architectural plan which uses the least building resources.

8. The method according to claim 6, wherein the method comprises a further subsequent step of selecting for construction, among the validated architectural plans, the architectural plan, the building resources and/or properties of which generate the least environmental impact according to a predetermined metric.

9. The method according to any of claims 1 to 8, wherein the representation of building requirements is provided in textual and/or in graphical form.

10. The method according to any of claims 1 to 9, wherein the method comprises a subsequent step of displaying, using display means, said validated or selected architectural building plan, together with the corresponding building resources allocated for the construction of the building.

11. A device comprising at least one memory element and computing means configured to perform the method steps according to any of claims 1 to 10.

12. The device according to claim 11, further comprising image acquisition means and/or display means, operatively connected to said computing means.

13. A computer capable of carrying out the method according to any of claims 1 to 10.

14. A computer program comprising computer readable code means, which when they are run on a computer, causes the computer to carry out the method according to any of claims 1 to 10.

15. A computer program product comprising a computer-readable medium on which the computer program according to claim 14 is stored.
